# EUROPEAN PATENT APPLICATION

(11) **EP 1 630 883 A2**
(43) Date of publication of application: **01.03.2006**
(21) Application number: 05254258.6
(22) Date of filing: 07.07.2005
(51) Int. Cl.: H01L 51/00

(54) **Molecular photovoltaics**

(30) Priority: 28.07.2004 US 900624
(71) Applicant: GENERAL ELECTRIC COMPANY, Schenectady, NY 12345 (US)
(72) Inventor: Gui, John Yupeng, Niskayuna New York 12309 (US); Duggal, Anil Raj, Niskayuna New York 12309 (US); Alizadeh, Azar, Wilton New York 12831 (US); Spivack, James Lawrence, Cobleskill New York 12043 (US); Cella, James Anthony, Clifton Park New York 12065 (US); Yakimov, Aharon, Niskayuna New York 12309 (US)
(74) Representative: Pedder, James Cuthbert

(57) **Abstract**

Disclosed herein is a photovoltaic cell (10) comprising an absorber (18) that can absorb electromagnetic radiation; a first substrate (20) comprising a first conductive surface; a second substrate (22) comprising a second conductive surface that is opposed to the first conductive surface and faces the first conductive surface of the first substrate (20); an electron transporter (14) that is in electrical communication with the second conductive surface of the second substrate (22), but is electrically insulated from the first substrate (20); a hole transporter (12) that is in electrical communication with the first conductive surface of the first substrate (20), but is electrically insulated from the second substrate (22); wherein the hole transporter (12) and/or the electron transporter (14) are chemically bonded to an electrically insulating sheath (16); and wherein the hole transporter (12) and/or the electron transporter (14) are chemically bonded to the absorber (18).

## Description

This disclosure relates to molecular photovoltaics, methods of manufacture and the articles derived therefrom.

Photovoltaic systems convert light into electricity for a variety of applications. Photovoltaic systems are commonly known as "solar cells," so named for their ability to produce electricity from sunlight. Power production by photovoltaic systems may offer a number of advantages over other systems of generating electricity. These advantages are low operating costs, high reliability, modularity, low construction costs, as well as environmental benefits.

Solar cells convert light into electricity by exploiting the photovoltaic effect that exists at semiconductor junctions. Accordingly, solar cells generally comprise semiconductor layers to produce electron current. The semiconductor layers absorb incoming light to produce excited electrons. In addition to the semiconductor layers, solar cells generally include a glass cover or other encapsulant, an anti-reflective layer, a front contact substrate to allow the electrons to enter a circuit, and a back contact electron to allow the electrons to complete the circuit when excited electrons are injected into the semiconductor layer due to light exposure.

In recent years progress has been made on the development of organic and inorganic-organic hybrid solar cells. These types of solar cells can be advantageously manufactured at a relatively low cost. One low cost solar cell is a dye-sensitized solar cell. A dye-sensitized solar cell generally uses an organic dye to absorb incoming light to produce excited electrons. The dye-sensitized solar cell generally includes two planar conducting substrates arranged in a sandwich configuration. A dye-coated semiconductor film separates the two substrates. The semiconductor film is porous and has a high surface area thereby allowing sufficient dye to be attached as a molecular monolayer on its surface to facilitate efficient light absorption. The remaining intervening space between the substrates and the pores in the semiconductor film (which acts as a sponge) is filled with an organic electrolyte solution containing an oxidation/reduction couple such as triiodide/iodide.

Dye-sensitized films however suffer from several technical drawbacks. One technical drawback is that a large transport distance results in substantial recombination or back reactions of electrons because the photo-generated electrons have to travel through the semiconductor film by a "random walk" through the adjacent particles of the film towards one substrate. Back reactions occur when a hole ejected into the hole transporter contacts an electron that has been ejected into the electron transporter. Recombination occurs when an electron that has been ejected from a dye recombines with the oxidized absorber.

Furthermore, oxidized dyes formed by the ejection of the electrons are generally reduced by a transfer of electrons from a reduced species in the photovoltaic cell. The reduced species are generally present in an electrolyte, that in turn, becomes an oxidized species in the electrolyte (after giving up the electron). This oxidized species has to migrate toward the opposite substrate through the same long and torturous diffusion path. The oxidized species get reduced by receiving the electron from the substrate to complete the circuit.

During the random walk of the electron to the substrate, the electron may travel a significant distance, and the electron may be lost by combining with a component of the electrolyte solution. This is also known as "recombination." Under irradiation by sunlight, the density of electrons in the semiconductor may be very high such that such losses significantly reduce the maximum voltage and therefore the efficiency achievable by the solar cells. One technique for reducing the travel distance of the electron is to reduce the thickness of the semiconductor film and thus, the distance the electron has to travel to reach a substrate. Disadvantageously, reduction in the thickness of the semiconductor film may reduce the light absorption due to lower dye loading, thereby reducing the efficiency of the solar cell.

Another technical drawback of the current dye-sensitized solar cell is that the poor electron conduction of the TiO₂ film consisting of randomly interconnected nano-particles. TiO₂ films are generally used as electron transporters in solar cells. Further, in solar cells (photovoltaic cells) it is difficult to maximize the interfacial area of the TiO₂ electron transporter for optimal loading of the dye.

It is therefore advantageous to minimize recombination ad back-reactions by reducing the travel path of the electron and thereby reduce the length of time it takes for the electron to diffuse to the substrate while at the same time reducing the hole transport distance to another substrate. It is therefore desirable to develop solar cells or photovoltaic cells that have reduced charge transport distances and minimize or prevent recombinations and backreactions, and that can be easily mass produced.

According to a first aspect of the invention, there is provided a photovoltaic cell comprising an absorber that can absorb electromagnetic radiation; a first substrate comprising a first conductive surface; a second substrate comprising a second conductive surface that is opposed to the first conductive surface and faces the first conductive surface of the first substrate; an electron transporter that is in electrical communication with the second conductive surface of the second substrate, but is electrically insulated from the first substrate; a hole transporter that is in electrical communication with the first conductive surface of the first substrate, but is electrically insulated from the second substrate; wherein the hole transporter and/or the electron transporter are chemically bonded to an electrically insulating sheath; and wherein the hole transporter and/or the electron transporter are chemically bonded to the absorber.

According to a second aspect of the invention, there is provided is a photovoltaic cell comprising a first substrate comprising a first patterned electrically conductive surface; a second substrate comprising a second patterned electrically conductive surface that is opposed to the first conductive surface and faces the first conductive surface of the first substrate; an electron transporter that is in electrical communication with the second conductive surface of the second substrate, but is electrically insulated from the first substrate; a hole transporter that is in electrical communication with the first conductive surface of the first substrate, but is electrically insulated from the second substrate; and an absorber disposed between the electron transporter and the hole transporter; and wherein the absorber is capable of absorbing electromagnetic radiation.

According to a third aspect of the invention, there is provided a photovoltaic cell comprising a cylinder comprising a first intrinsically conducting polymer capable of transporting electrons to a second substrate; a matrix capable of conducting holes to a first substrate; wherein the matrix is optically transparent and surrounds the cylinder, but is not in electrical communication with it; a sheathed layer disposed between the cylinder and the matrix and in intimate contact with the cylinder and the matrix; wherein the sheathed layer comprises electrically insulating molecules and is at least one monolayer thick; an absorber chemically bonded to the first intrinsically conducting polymer and disposed between the cylinder and the matrix in a manner such that it is in electrical communication with the cylinder while being electrically insulated from the matrix; and wherein the absorber is capable of absorbing electromagnetic radiation of wavelengths of about 300 to about 1,100 nanometers; and wherein the first substrate and the second substrate are in electrical communication with one another.

According to a fourth aspect of the invention, there is provided a photovoltaic composition comprising an electron transport molecule optionally bonded to an electrically insulating molecule; a hole transport molecule optionally bonded to an electrically insulating molecule; and an absorber that is capable of absorbing electromagnetic radiation; wherein the absorber is chemically bonded to the electron transport molecule and the hole transport molecule.

According to a fifth aspect of the invention, there is provided a method of manufacturing a photovoltaic cell comprising blending a composition comprising an absorber that is capable of absorbing electromagnetic radiation; an electron transporter and/or a hole transporter; and an electrically insulating molecule; and depositing the composition upon a substrate.

The invention will now be described in greater detail, by way of example, with reference to the drawings, in which:-
Figure 1 is a schematic depiction of one embodiment of the photovoltaic cell wherein the electromagnetic energy is incident upon an absorbing molecule chemically bonded to an electron transporter and to a hole transporter is converted to electrical energy;
Figure 2 is a schematic depiction of one embodiment of the photovoltaic cell wherein the electron transporter and hole transporter form an interpenetrating structure;
Figure 3 is a depiction of one embodiment of the photovoltaic cell wherein the process of self-assembly promotes the electron transporter and the hole transporter to phase separate into phases having at least one dimension that are on the order of molecules; and
Figure 4 is a depiction of one embodiment of the photovoltaic cell wherein the end groups of the electron transport polymers are designed to bind to the respective substrates and wherein the electron transport polymer is encapsulated in fiber form.

It is to be noted that as used herein, the terms "first," "second," and the like do not denote any order or importance, but rather are used to distinguish one element from another, and the terms "the", "a" and "an" do not denote a limitation of quantity, but rather denote the presence of at least one of the referenced item. Furthermore, all ranges disclosed herein are inclusive of the endpoints and independently combinable.

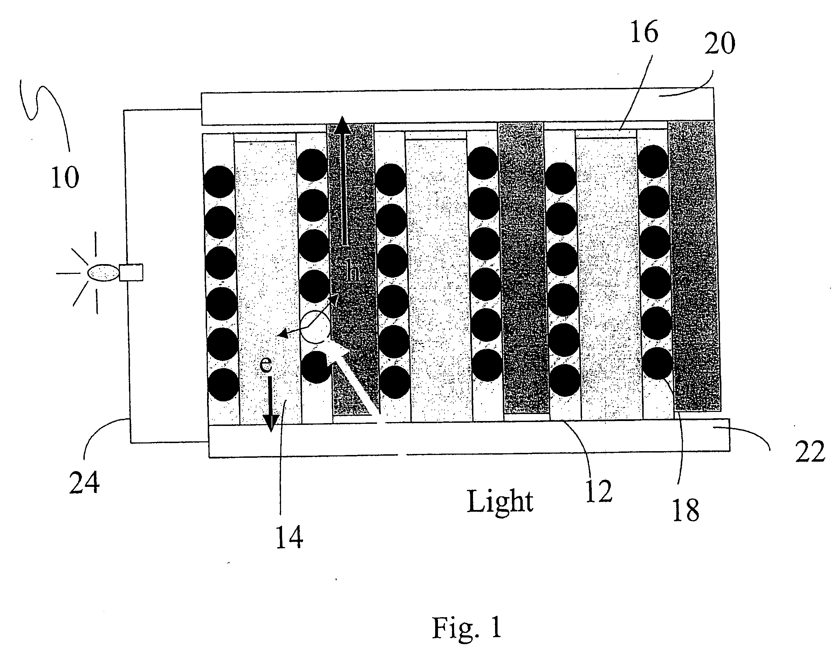

With reference to the exemplary embodiment depicted in the Figure 1, a photovoltaic cell 10 comprises at least a pair of interdigitated fingers 12 and 14 that comprise a hole transporter and an electron transporter respectively. An electrically insulating sheath 16 that electrically insulates the hole transport fingers 12 and the electron transport fingers 14 from each other. An absorber 18 is chemically bonded to the electron transport finger and the hole transport finger. There are two substrates that are in electrical communication with any one of the interdigitated fingers. Each substrate has at least one electrically conductive surface that is in electrical communication with an interdigitated finger. The conductive surface of the substrate functions as an electrode. A first substrate 20 comprises a first surface that communicates electrically with the hole transport finger 12 while the second substrate 22 comprises a second surface that communicates with the electron transport finger 14. The first and the second surfaces of the respective substrates are opposed to each other and face each other. The hole transport finger 12, the electron transport finger 14, the electrically insulating sheath 16 and the absorbing molecule 18 are disposed between the first surface of the first substrate 20 and the second surface of the second substrate 22.

In one embodiment, the hole transport finger 12, the electron transport finger 14 and/or the insulating sheath 16 have at least one dimension that is of a molecular size. By utilizing an insulating sheath as well as hole transport and electron transport fingers that have molecular dimensions, electron recombination and back-reactions are minimized, thereby increasing the efficiency of the photovoltaic cell. In addition, the photovoltaic cell created by self-assembly can result in a nanostructure that is either random or well ordered. Self assembly provides a high interfacial surface area with minimal charge transport distances and minimal recombination or back-reactions.

In one embodiment, the photovoltaic cell is formed by self-assembly of a photovoltaic composition. The photovoltaic composition comprises the electron transporter, the hole transporter, and the absorber, all of which are chemically bonded to each other. In yet another embodiment, the photovoltaic composition comprises the electron transporter, the hole transporter, the insulating molecule and the absorber, all of which are chemically bonded to each other. The photovoltaic composition self-assembles into the interdigitated fingers, which can then be used to form the photovoltaic cell.

The interdigitated fingers 12 and 14 comprise alternating phases that comprise either an electron transporter or a hole transporter. The phase that comprises the electron transporter is separated from the phase that comprises the hole transporter by the electrically insulating sheath 16. Both the interdigitated fingers have a first end and a second end. Only one end (i.e., either the first end or the second end) of any interdigitated finger is in electrical communication with a conductive surface of the substrate at any given time. For example, while the first end of the interdigitated finger that comprises the electron transporter is in electrical communication with the second substrate, the second end is electrically insulated from the first substrate. Similarly, at the same time, while the first end of the interdigitated finger that comprises the hole transporter is in electrical communication with the first substrate, the second end is electrically insulated from the second substrate. In one embodiment, the interdigitated fingers can be chemically bonded to the substrates. In another embodiment, the interdigitated fingers are in disposed upon the substrates without being chemically bonded to them.

The interdigitated fingers can form ordered or random structures. Examples of random structures include interpenetrating structures such as for example interpenetrating networks, bi-continuous structures, or the like, or combinations comprising at least one of the foregoing structures. Examples of ordered structures include lamellar structures, layered structures, closed packed structures, or the like, or combinations comprising at least one of the foregoing structures.

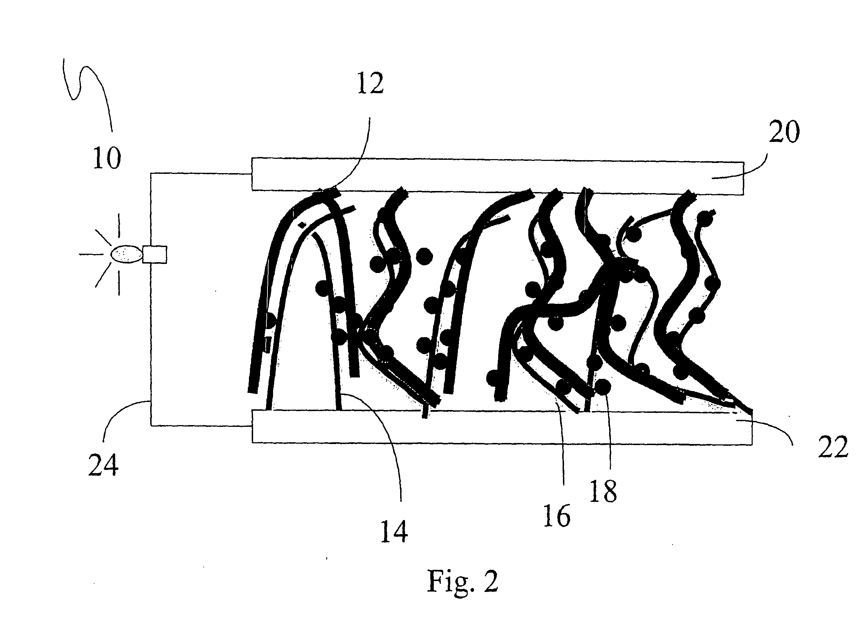

Figure 2 shows interdigitated fingers comprising an electron transporter and a hole transporter that form an interpenetrating structure. In the Figure 2, the electron transport finger 14 is in electrical communication with the second substrate 22, while the hole transport finger 12 is in electrical communication with the first substrate 20. The electron transport finger 14 does not communicate electrically with the first substrate 20, while the hole transport finger 12 does not communicate electrically with the second substrate 22. Disposed upon either the electron transport finger 14 and/or the hole transport finger 12 is an electrically insulating sheath 16. An absorber 18 can be chemically bonded to the electron transport finger 14 and/or to the hole transport finger 12. The absorber is generally chemically bonded to both the electron transporter and the hole transporter.

With reference again to the photovoltaic cell 10 of Figure 1, when light impinges upon the absorbing molecule 18, it absorbs short and long wavelength infra-red radiation and ejects an electron. As shown in the Figure 1, the electron is ejected into the electron transport finger 14 and travels to the second substrate 22. A hole is simultaneously ejected into the hole transport finger 12 and travels to the first substrate 20. The electron then travels through an external electrical circuit 24 and recombines with the hole to produce electricity. The external electrical circuit 24 as referenced herein pertains to elements that are in electrical communication with the substrates and not in communication with the internal components of the photovoltaic cells such as the absorbing molecule, the electron and hole transporter, the insulating molecules, charge separators or ionic dopants.

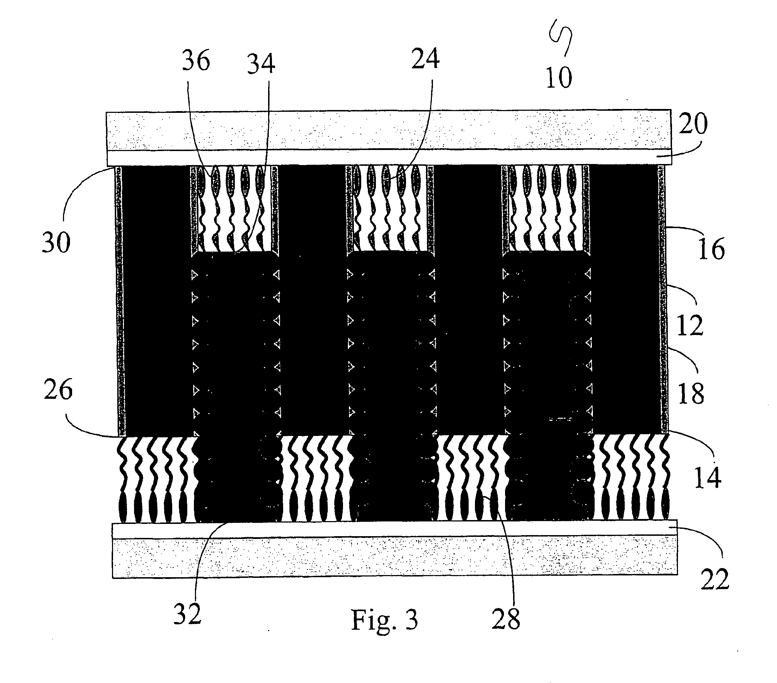

In another embodiment of a photovoltaic cell 10 depicted in Figure 3, a first end of the interdigitated fingers (e.g., the hole transport finger 12 or the electron transport finger 14) contacts either the first substrate 20 and/or the second substrate 22, while the second end (which is opposed to the first end) is prohibited from electrically communicating with the substrates by a self-assembled monolayer. As seen in Figure 3, the hole transport finger 12 has a first end 26 upon which is disposed an insulating self-assembled monolayer 28 (SAM). The self-assembled monolayer 28 is disposed upon and in intimate contact with the second surface of the second substrate 22. The second end 30 of the hole transport finger 12 is opposed to the first end 26. The second end 30 is disposed upon and in electrical communication with the first surface of the first substrate 20.

In a similar manner, the electron transport finger 14 has a first end 32 that is in electrical communication with the second surface of the second substrate 22, while the first end 34 has a self-assembled monolayer 36 that prevents the electron transport finger 14 from being in electrical communication the first substrate 20. The self-assembled monolayers 26 and 36 are generally electrically insulating. The conductive surfaces of the first substrate 20 and/or the second substrate 22 can be manufactured from electrically conductive nanowires. In one embodiment, the self-assembled monolayer can be chemically bonded to the nanowires on the first substrate 20 and the second substrate 22. In another embodiment, the first and second conductive surfaces of the first and second substrates may be manufactured from electrically conductive metals, semiconductors, or inherently conducting polymers.

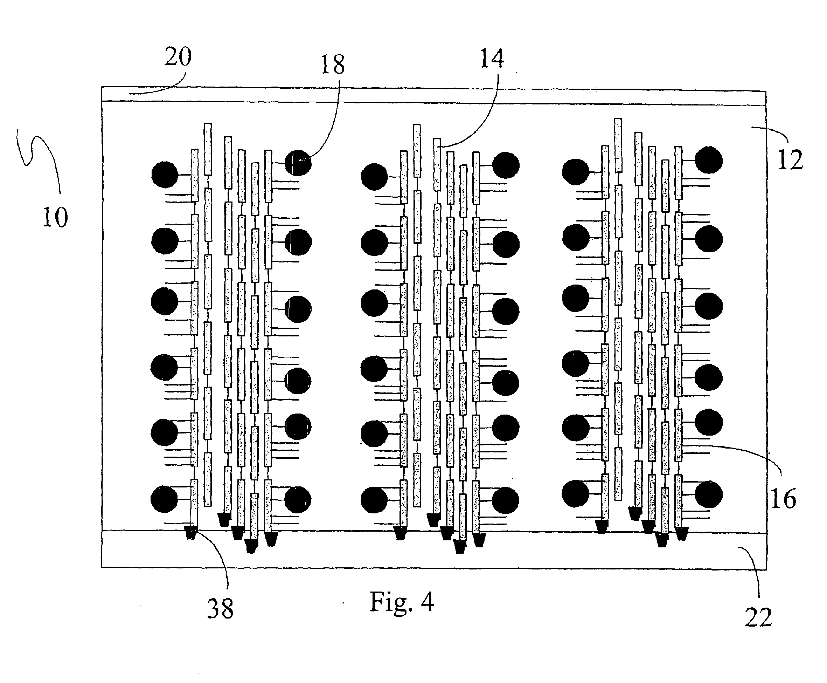

In yet another embodiment, depicted in the Figure 4, the photovoltaic cell 10 comprises at least one interpenetrating phase that is in the form of a fiber. As seen in the Figure 4, the electron transport finger 14 is formed from a fiber. The fiber comprises reactive groups 38 that can covalently bond to the second substrate 22. The reactive groups 38 facilitate in anchoring the finger 14 to the second substrate 22. This structure of the photovoltaic cell occurs because either the first substrate 20 or the second substrate 22 or both are first patterned so to contact only the reactive groups 38 that are chemically bonded to either the electron transporter or to the hole transporter. As a result of this patterning, a first set of selective reactions occurs between the electron transporter and the second substrate, while a second set of selective reactions may occur between the hole transporter and the first substrate. These selective reactions permit contact between desired sites on the fiber and desired sites on one substrate, while prohibiting contact between the remainder of the fiber and the opposing substrate.

As noted above, the photovoltaic cell is advantageously formed by the self-assembly of a photovoltaic composition. This photovoltaic composition advantageously comprises molecules that utilize a process comprising self-assembly to self-assemble into layers having a geometry and a thickness effective to permit the efficient absorption of light, while shortening exciton transport distances to less than or equal to about 100 nanometers (nm), and consequently facilitating charge transport. The process of self-assembly results in phase separation to produce at least one interdigitated finger. An interdigitated finger is one that has an aspect ratio of greater than or equal to about 1 and which is in either direct or indirect physical contact with another finger at any point along it surface. A direct contact is one in which one interdigitated finger physically contacts another interdigitated finger at any point along its surface. For example, an electron transport finger may directly contact a hole transport finger at any point on the hole transport finger's surface. An indirect contact is one in which one interdigitated finger contacts another material or layer, wherein the material or layer is in contact with another interdigitated finger. For example, an electron transport finger may indirectly contact a hole transport finger through an electrically insulating sheath.

In one embodiment, the interdigitated fingers comprise alternating phases that comprise either an electron transporter or a hole transporter. The interdigitated fingers generally have a length that is greater than the other dimensions. The interdigitated fingers can have a cross-sectional area that has any geometry. In one embodiment, the interdigitated fingers have a cross-sectional area that is rectangular and/or square and the fingers are arranged in the form of layers. Such layers are generally termed lamellae. In another embodiment, at least one of the interdigitated fingers has a circular cross-section. In this event, the process of self-assembly may result in an arrangement comprising closed packed cylinders, with the cylindrical interdigitated finger being surrounded by a matrix. If the cylindrical finger is comprised of the electron transporter, then the matrix comprises the hole transporter or vice versa. Other suitable cross-sectional geometries for the interdigitated finger are triangular, polygonal, tubular (i.e., concentric circles) or the like, or a combination comprising at least one of the foregoing.

As noted above, the interdigitated fingers have at least one molecular dimension. By reducing the size of the phases to molecular dimensions, the efficiency of the photovoltaic cell is increased and the recombination or back-reactions of an electron with a hole outside the external circuit 24 is minimized. It is desirable for the hole transport finger or the electron transport finger to have at least one dimension that is greater than or equal to about 2 nanometers. In one embodiment, it desirable for the hole transport finger or the electron transport finger to have at least one dimension that is greater than or equal to about 3 nanometers. In yet another embodiment, it desirable for the hole transport finger or the electron transport finger to have at least one dimension that is greater than or equal to about 5 nanometers. It is generally desirable for the electron transport finger or the hole transport finger to have at least one dimension that is less than or equal to about 100 nanometers. In one embodiment, it is generally desirable for the electron transport finger or the hole transport finger to have at least one dimension that is less than or equal to about 75 nanometers. In another embodiment, it is generally desirable for the electron transport finger or the hole transport finger to have at least one dimension that is less than or equal to about 50 nanometers.

The photovoltaic composition comprises an absorber that is chemically bonded to the electron transporter and/or the hole transporter. The absorber can be a polarized molecule i.e., it can be capable of absorbing electromagnetic energy from any wavelength of the electromagnetic spectrum and ejecting an electron. The ejected electron travels to the electron transporter. The chemical bonding can be covalent bonding, ionic bonding, hydrogen bonding, or any other form of bonding. The absorber comprises an absorbing molecule and a charge separator. The function of the charge separator is to reduce the rate of electron transfer back from the electron transporter to the absorber.

The charge separator is a molecular moiety bonded to the absorber with the following characteristics. The charge separator is a reducing agent, which is capable of providing an electron to the oxidized absorber after the absorber injects an electron into the electron transporter. Therefore the energy of the highest occupied molecular orbital (HOMO) of the charge separator is higher (more negative) than the HOMO of the absorber by about 100 milli-electron volts (meV) or more. The charge separator can deliver this electron very quickly so that the oxidized dye molecule does not have time to recombine with electrons in the electron transporter. After this electron transfer from charge separator to the absorber the charge separator is in an oxidized state. The oxidized state can accept an electron from a reducing agent in the hole transporter faster than any other reaction it might otherwise take place. In order to accept the electron from the hole transporter, the HOMO of the charge separator must be lower in energy than the HOMO of the hole transporter. In other words, the reduction potential of the charge separator can be more positive than that of the hole transporter, in either case by about 100 meV or more.

In one embodiment, the absorbing molecule can eject an electron after absorbing radiation over the entire electromagnetic spectrum. In another embodiment, the absorbing molecule comprises a low wavelength infrared absorbing molecule that is chemically bonded to a long wavelength infrared absorbing molecule. The low wavelength infrared absorbing molecule absorbs radiation having wavelengths of about 300 nanometers (nm) to about 700 nm, while the long wavelength absorbing molecule absorbs radiation having wavelengths of about 700 to about 1,100 nm.

It is desirable for the absorbing molecule to be chemically incompatible with the electron transporter and the hole transporter, so that upon casting from a solution or upon cooling from a melt, the absorbing molecule is excluded from being present in the same phase as the electron transporter and the hole transporter. It is desirable upon self-assembly for the absorbing molecule to be disposed upon the outer surface of a phase that comprises either the electron transporter or the hole transporter. This facilitates the efficient absorption of long or short wavelength infrared radiation. It is also desirable for the short wavelength and the long wavelength absorbing molecules to be chemically compatible with one another so that they can coexist in a single phase.

The absorbing molecule can eject electrons as a result of energy absorption. It is desirable for the absorbing molecule to be capable of rapid electron and hole injection. The absorbing molecule should be capable of preventing or minimizing recombination or back reactions outside of the external electrical circuit 24. In addition, the absorbing molecule should be capable of minimizing any side reactions.

The absorbing molecule can be an organic material, an inorganic-organic material, an organometallic material. In one embodiment, the absorbing molecule can be an organic material, an inorganic-organic material, an organometallic material, inorganic nano-material (such as quantum dots, nanoparticles made from traditional inorganic semiconductors, such as, for example, silicone, cadmium telluride (CdTe), gallium arsenide (GaAs)), or the like. The organic absorbing molecule can be a dye or a pigment. Examples of suitable dyes that can be used for absorbing infrared radiation are anthranones and their derivatives; anthraquinones and their derivatives; croconines and their derivatives; monoazos, disazos, trisazos and their derivatives such as an azo pigments having a triphenylamine structure, azo pigments having a carbazole structure, azo pigments having a fluorene structure, azo pigments having an oxadiazole structure, azo pigments having a bisstilbene structure, azo pigments having a dibenzothiophene structure, azo pigments having a distyrylbenzene structure, azo pigments having a distyrylcarbazole structure, azo pigments having a distyryloxadiazole structure, azo pigments having a stilbene structure, trisazo pigments having a carbazole structure, azo pigments having an anthraquinone structure, bisazo pigments having a diphenylpolyene structure; benzimidazolones and their derivatives; diketo pyrrole pyrroles and their derivatives; dioxazines and their derivatives; diarylides and their derivatives; indanthrones and their derivatives; isoindolines and their derivatives; isoindolinones and their derivatives; naphtols and their derivatives; perinones and their derivatives; perylenes and their derivatives such as perylenic acid anhydride or perylenic acid imide; ansanthrones and their derivative; dibenzpyrenequinones and their derivatives; pyranthrones and their derivatives; bioranthorones and their derivatives; isobioranthorone and their derivatives; diphenylmethane and triphenylmethane type pigments; cyanine and azomethine type pigments; indigoid type pigments; bisbenzoimidazole type pigments; azulenium salts; pyrylium salts; thiapyrylium salts; benzopyrylium salts; phthalocyanines and their derivatives, pryanthrones and their derivatives; quinacidones and their derivatives; quinophthalones and their derivatives; squaraines and their derivatives; squarilyiums and their derivatives; or the like, or a combination comprising at least one of the foregoing dyes.

Examples of the suitable metal organometallic complexes that can absorb infra red radiation are crystalline titanyl phthalocyanines, copper phthalocyanine, aluminum phthalocyanine, zinc phthalocyanine, α type, β type or Y type oxotitanyl phthalocyanine, nickel phthalocyanine, lead phthalocyanine, palladium phthalocyanine, cobalt phthalocyanine, hydroxygallium phthalocyanine, chloroaluminum phthalocyanine, chloroindium phthalocyanine, or the like, or a combination comprising at least one of the foregoing metal complexes.

It is desirable for the absorbing molecule to have functional groups by means of which it can be reacted with and chemically bonded to the electron transporter and the hole transporter. It is also desirable for the absorbing molecule to have a charge separator between absorbing molecule and the hole transporter. Since the ejected electron can migrate directly to an oxidized absorber molecule (which represents a hole on the electron transporter surface) it is desirable for the absorbing molecule to have a charge separator chemically bonded to the absorbing molecule to prevent a direct recombination of the electron with the oxidized absorber. The absorbing molecule may also be chemically bonded to electrically insulating molecules to minimize unwanted electron transfers such as direct reaction with the hole transporter. The insulating molecules prevent and/or minimize recombination of electrons with holes outside of the desired electrical circuit. These insulating molecules that form the insulating sheath 16 prevent recombination of the electrons with the holes outside of the electrical circuits.

As noted above, it is desirable for the charge separator to facilitate the flow of electrons from the hole transporter to the absorber more rapidly than electron recombination with oxidized absorber can occur. The charge separator can comprise an electron donating moiety. Examples of suitable charge separators are substituted phenothiazine moieties, substituted carbazole moieties, substituted dibenzochalcophene moieties, substituted triarylamines, thiophenes, or the like.

As noted above, electrically insulating molecules are chemically bonded to the absorbing molecules and/or to the electron transporter and/or the hole transporter in order to minimize or prevent recombination of the electrons with holes. These electrically insulating molecules generally comprise monomers, dimers, trimers, oligomers and/or polymers that do not have conjugated backbones and which therefore are not inherently electrically conducting. In one embodiment, these electrically insulating molecules can be thermoplastic polymers or thermosetting polymers. The thermoplastic polymers can include dendrimers, ionic polymers, copolymers such as block copolymers, graft copolymers, random copolymers, star block copolymers, or the like. Monomers and/or oligomers are generally desirable for use as insulating molecules. The electrically insulating molecules form an electrically insulating sheath, which minimizes electrical communication between the hole transporter and the electron transporter. The insulating sheath can comprise a partial monolayer, a monolayer or a multilayer system. Examples of suitable electrically insulating molecules are non-electrically conductive inorganic compounds, inorganic compounds, non-conjugated monomers, non-electrically conductive oligomers and polymers, or the like, or a combination comprising at least one of the foregoing electrically insulating molecules. The electrically insulating molecules can form nanostructures such as nanoparticles, nanosheets, nano-rods, or the like.

Examples of suitable oligomers and/or polymers that may be used as insulating molecules are polyacetals, polyurethanes, polyolefins, polyacrylics, polycarbonates, polyalkyds, polystyrenes, polyesters, polyamides, polyaramides, polyamideimides, polyarylates, polyarylsulfones, polyethersulfones, polyphenylene sulfides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, polycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, or a combination comprising at least one of the foregoing organic polymers. Monomers used for making these polymers can also be used for making the electrically insulating sheath. Electrically insulating nanoparticles can also be used in the electrically insulating sheath.

As noted above, monomers used for manufacturing the aforementioned polymers may also be used as insulating molecules. It is generally desirable for the insulating molecules to form an insulating sheath 16 that is disposed upon the electron transport finger 14 during and/or after the self-assembly has occurred. The sheath is in intimate contact with the electron transport finger 16 and prevents or minimizes recombination of the electrons with the holes outside of the external electrical circuit 24. It is desirable for the insulating sheath to have a thickness of greater than or equal to about 0.2 nanometers. In one embodiment, it is desirable for the insulating sheath to have a thickness of greater than or equal to about 0.4 nanometers. In another embodiment, it is desirable for the insulating sheath to have a thickness of greater than or equal to about 1.0 nanometers.

The hole transport finger or the hole transport matrix 12 comprises a hole transporter (hole transporter) that provides a high mobility for holes. In one embodiment, it is desirable to have a void-filling, transparent hole transporter that is processable as a liquid, but convertible to solid-state at the operating conditions of the photovoltaic cell. Furthermore, it is desirable for the hole transporter to be transparent to light having wavelengths of about 300 to about 1,100 nanometers. In one embodiment, the hole transporter has a transmissivity for light of greater than or equal to about 10%. In another embodiment, the transparent hole transporter has a transmissivity for light of greater than or equal to about 20%. In yet another embodiment, the transparent hole transporter has a transmissivity for light of greater than or equal to about 40%.

It is also desirable for the hole transporter to have a highest occupied molecular orbital (HOMO) energy level that closely matches the HOMO of the absorber to facilitate the transport of holes between the absorber and the hole transporter.

Suitable hole transporters are represented by the structures (I) through (VIII) shown below: 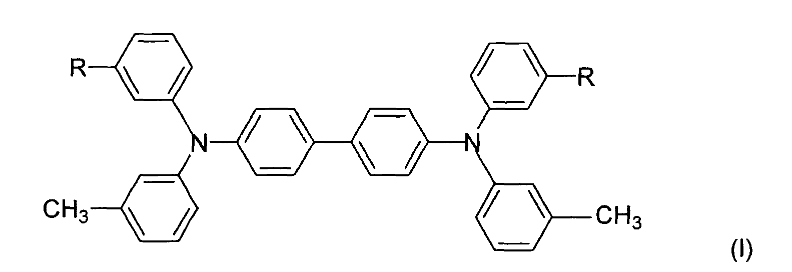
where R is hydrogen or alkyl. A suitable alkyl group is a methyl group. 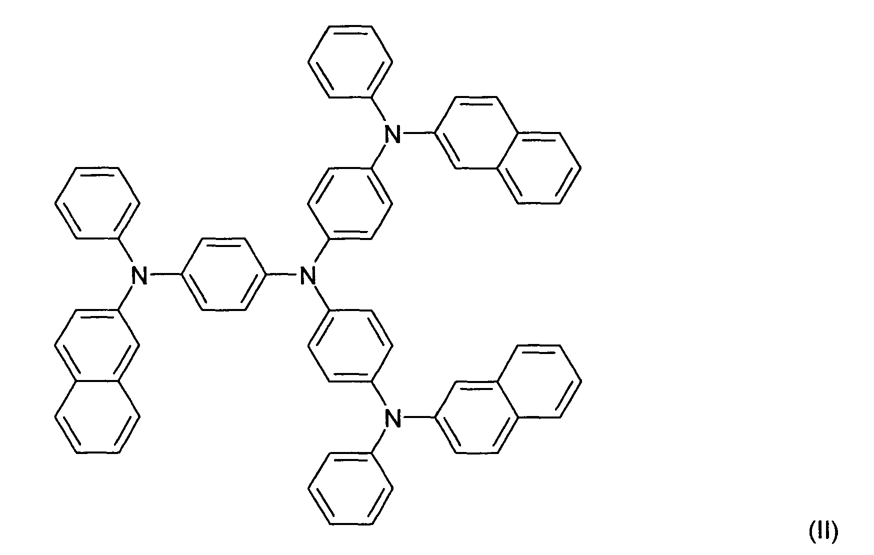 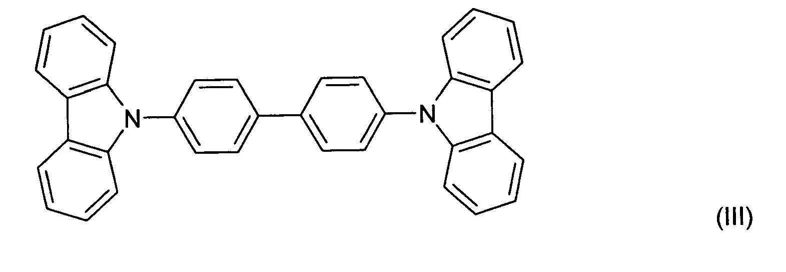 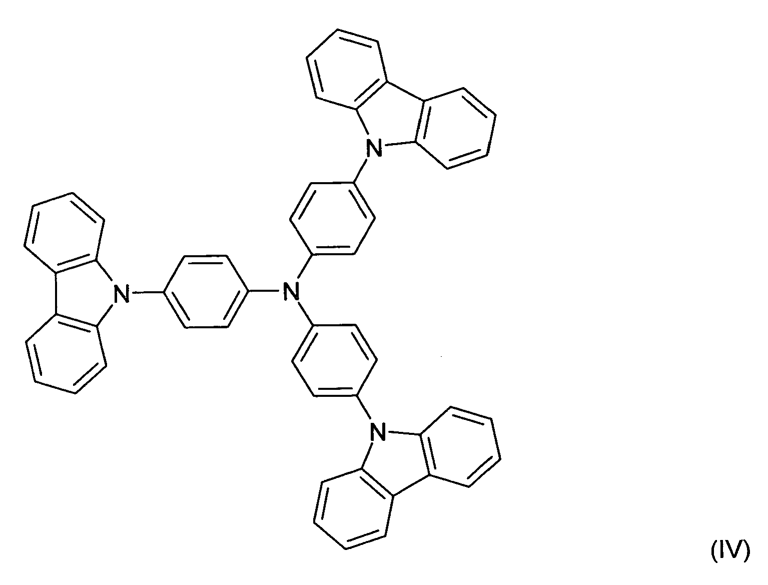 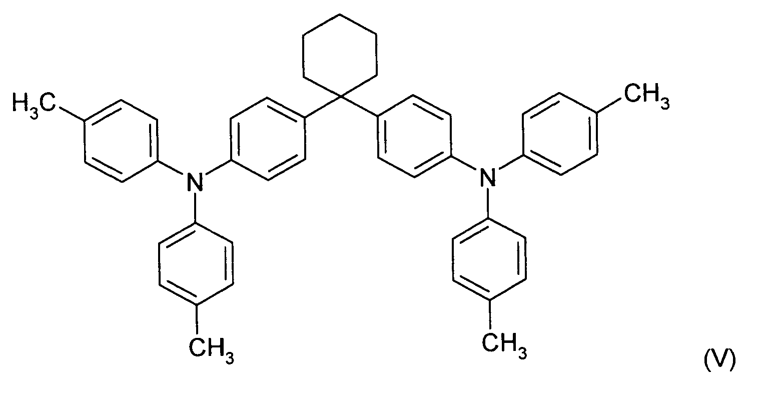 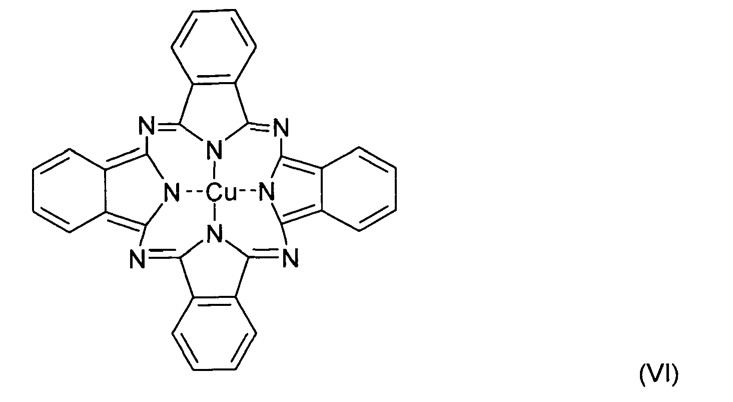 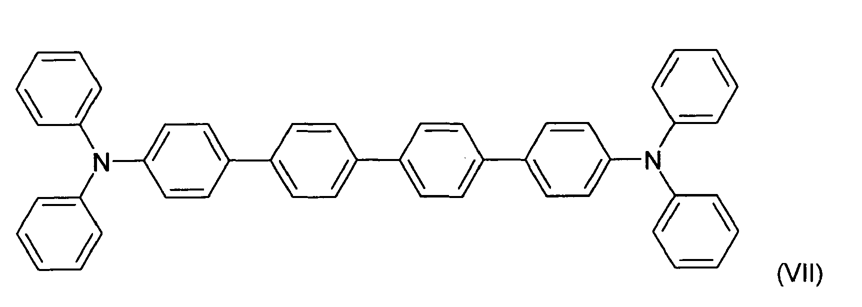 and 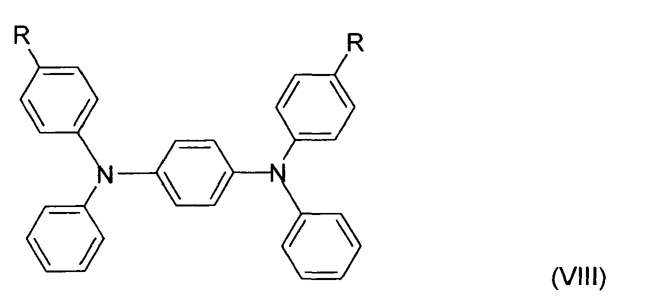
where R is hydrogen and/or alkyl. A suitable alkyl group is a methyl group.

Other examples of suitable hole transporters include hydrazone compounds, styryl compounds, diamine compounds, aromatic tertiary amine compounds, butadiene compounds, indole compounds, carbazole derivatives, triazole derivatives, imidazole derivatives, oxadiazole derivatives having an amino group, or the like, or a combination comprising at least one of the foregoing materials.

Yet other examples of suitable hole transporters are triphenylmethane, bis(4-diethylamine-2-methylphenyl) phenylmethane, stylbene, hydrozone; aromatic amines comprising tritolylamine; arylamine; enamine phenanthrene diamine; N,N'-bis-(3,4-dimethylphenyl)-4-biphenyl amine; N,N'-bis-(4-methylphenyl)-N,N'-bis(4-ethylphenyl)-1,1'-3,3'-dimethylbiphenyl)-4,4'-diamine; 4-4'-bis(diethylamino)-2,2'- dimethyltriphenylmethane; N,N'-diphenyl-N,N'-bis(3-methylphenyl)-[1,1'- biphenyl]-4,4'-diamine; N,N'-diphenyl-N,N'-bis(4-methylphenyl)-1,1'- biphenyl-4,4'-diamine; N,N'-diphenyl-N,N'-bis(alkylphenyl)-1,1'-biphenyl-4,4'-diamine; and N,N'-diphenyl-N,N'-bis(chlorophenyl)-1,1'-biphenyl-4,4'-diamine; 1,1-bis(4-di-p-tolylaminophenyl)cyclohexane; 1,1-bis(4-di-p-tolylaminophenyl)-4-phenylcyclohexane; 4,4'-bis(diphenylamino)quadriphenyl; bis(4-dimethylamino-2-methylphenyl)-phenylmethane; N,N,N-Tri(p-tolyl)amine; 4-(di-p-tolylamino)-4'-[4(di-p-tolylamino)-styryl] stilbene; N,N,N',N'-tetra-p-tolyl-4-4'-diaminobiphenyl; N,N,N',N'-tetraphenyl-4,4'-diaminobiphenyl; N,N,N',N'-tetra-1-naphthyl-4,4'-diaminobiphenyl; N,N,N',N'-tetra-2-naphthyl-4,4'-diaminobiphenyl; N-phenylcarbazole; 4,4'-bis[N-(1-naphthyl)-N-phenylamino]biphenyl; 4,4'-bis[N-(1-naphthyl)-N-(2-naphthyl)amino]biphenyl; 4,4"-bis[N-(1-naphthyl)-N-phenylamino]p-terphenyl; 4,4'-bis[N-(2-naphthyl)-N-phenylamino]biphenyl; 4,4'-bis[N-(3-acenaphthenyl)-N-phenylamino]biphenyl; 1,5-bis[N-(1-naphthyl)-N-phenylamino]naphthalene; 4,4'-bis[N-(9-anthryl)-N-phenylamino]biphenyl; 4,4"-bis[N-(1-anthryl)-N-phenylamino]-p-terphenyl; 4,4'-bis[N-(2-phenanthryl)-N-phenylamino]biphenyl; 4,4'-bis[N-(8-fluoranthenyl)-N-phenylamino]biphenyl; 4,4'-bis[N-(2-pyrenyl)-N-phenylamino]biphenyl; 4,4'-bis[N-(2-naphthacenyl)-N-phenylamino]biphenyl; 4,4'-bis[N-(2-perylenyl)-N-phenylamino]biphenyl; 4,4'-bis[N-(1-coronenyl)-N-phenylamino]biphenyl; 2,6-bis(di-p-tolylamino)naphthalene; 2,6-bis[di-(1-naphthyl)amino]naphthalene; 2,6-bis[N-(1-naphthyl)-N-(2-naphthyl)amino]naphthalene; N,N,N',N'-tetra(2-naphthyl)-4,4"-diamino-p-terphenyl; 4,4'-bis {N-phenyl-N-[4-(1-naphthyl)-phenyl]amino} biphenyl; 4,4'-bis[N-phenyl-N-(2-pyrenyl)amino]biphenyl; 2,6-bis[N,N-di(2-naphthyl)amine]fluorine; 1,5-bis[N-(1-naphthyl)-N-phenylamino]naphthalene; or the like, or a combination comprising at least one of the foregoing

The hole transporters may also be inherently conducting polymers. Examples of suitable intrinsically conducting polymers are poly(acetylene) and its derivatives; poly(thiophenes) and its derivatives; poly(3,4-ethylenedioxythiophene) and poly(3,4-ethylenedithiathiophene) and their derivatives; poly(isathianaphthene), poly(pyridothiophene), poly(pyrizinothiophene), and their derivatives; poly(pyrrole) and its derivatives; poly(3,4-ethylenedioxypyrrole) and its derivatives; poly(aniline) and its derivatives; poly(phenylenevinylene) and its derivatives; poly(p-phenylene) and its derivatives; poly(thionapthene), poly(benzofuran), and poly(indole) and their derivatives; poly(dibenzothiophene), poly(dibenzofuran), poly(carbazole) and their derivatives; poly(bithiophene), poly(bifuran), poly(bipyrrole), and their derivatives; poly(thienothiophene), poly(thienofuran), poly(thienopyrrole), poly(furanylpyrrole), poly(furanylfuran), poly(pyrolylpyrrole), and their derivatives; poly(terthiophene), poly(terfuran), poly(terpyrrole), and their derivatives; poly(dithienothiophene), poly(difuranylthiophene), poly(dipyrrolylthiophene), poly(dithienofuran), poly(dipyrrolylfuran), poly(dipyrrolylpyrrole) and their derivatives; poly(phenyl acetylene) and its derivatives; poly(biindole) and derivatives; poly(dithienovinylene), poly(difuranylvinylene), poly(dipyrrolylvinylene) and their derivatives; poly(1,2-trans(3,4-ethylenedioxythienyl)vinylene), poly(1,2-trans(3,4-ethylenedioxyfuranyl)vinylene), poly(1,2-trans(3,4-ethylenedioxypyrrolyl)vinylene), and their derivatives; poly(bis-thienylarylenes) and poly(bis-pyrrolylarylenes) and their derivatives; poly(dithienylcyclopentenone); poly(quinoline); poly(thiazole); poly(fluorene); poly(azulene); or the like, or a combination comprising at least one of the foregoing intrinsically conducting polymers.

The hole transporter can also be an ionic liquid or an electrolyte. Suitable examples of ionic liquids that are used as the hole transporter are methylpropylimidazolium triflate, methylpropylimidazolium bistriflimide, methylpropylimidazolium nanoflate, methylpropylimidazolium ethersulfonate, methylpropylimidazolium iodide methylpropylimidazolium triiodide, methylpropylimidazolium psedohallides, metal complex cations with phosphonium anion, or the like, or a combination comprising at least one of the foregoing hole transporters.

The electron transporter generally has the same general properties as the hole transporter material i.e., it is capable or transporting electrical charges. It is thus desirable for the electron transporter to have a lowest unoccupied molecular orbital (LUMO) energy level that closely matches the LUMO of the absorber to facilitate the transport of electrons between the absorber and said electron transporter.

In one embodiment, the electron transporter comprises nanostructures such as nanowires, nano-rods, nanosheets, that can comprise metals, semiconductors, inherently conducting polymers, or combinations comprising at least one of the foregoing materials. An exemplary electron transporter is a titanium oxide nanowire that has absorbers and/or insulating molecules chemically bonded to its outer surface. In one embodiment, the nanowires may be aligned in a bundle to form the electron transport finger 14.

Examples of suitable electron transporters inorganic complexes, such as tris-8-hydroxyquinolato aluminum (AIQ₃), cyano-polyphenylene vinylene (CN-PPV), oligomers, polymers and other molecular species containing electron deficient heterocyclic moieties, such as 2,5-diaryloxadiazoles, diaryl trazoles, triazines, pyridines, quinolines, benzoxazoles, benzthiazoles, or the like. Other exemplary electron transporters are particularly functionalized fullerenes (e.g., 6,6-phenyl-C61-butyl acid-methylester), difluorovinyl-(hetero)arylenes, 3-(1,1-difluoro-alkyl)thiophene group, pentacene, poly(3-hexylthiophene), α,ω-substituted sexithiophenes, n-decapentafluoroheptyl-methylnaphthalene -1,4,5,8-tetracarboxylic diimide, dihexyl-quinquethiophene, poly(3-hexylthiophene), poly(3-alkylthiophene), di-hexyl-hexathiophene, dihexyl-anthradithiophene, phthalocyanine, C60 fullerene, or the like, or a combination comprising at least one of the foregoing electron transporters.

Suitable examples of electron transport but hole blocking materials are shown in the structures (IX) through (XIII)

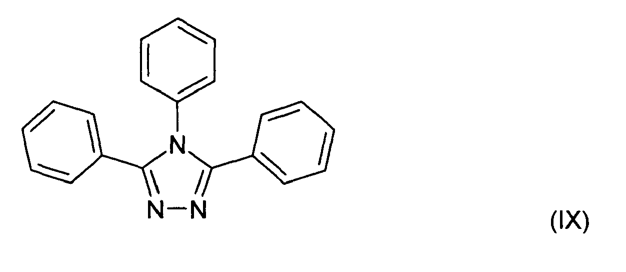

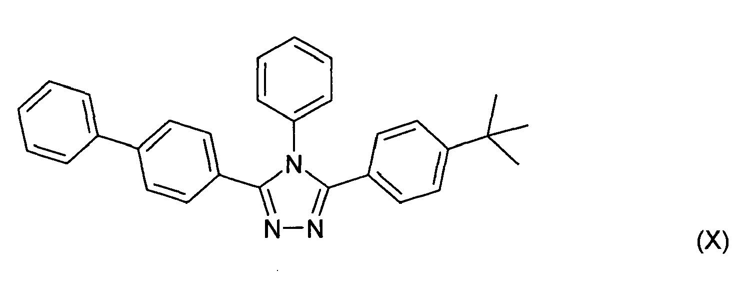

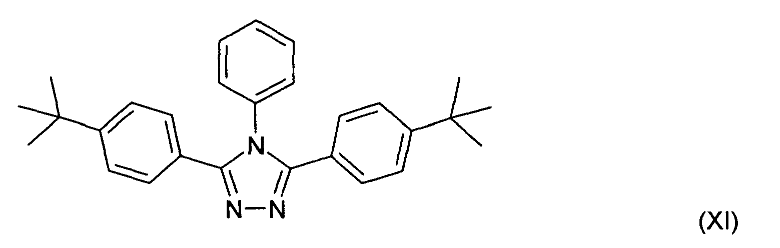

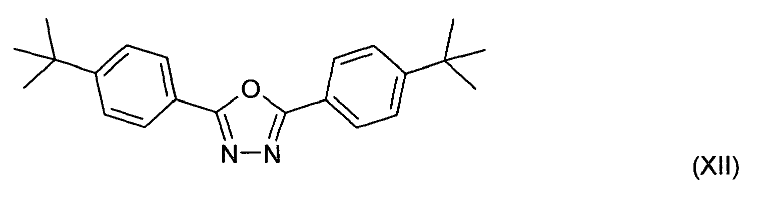

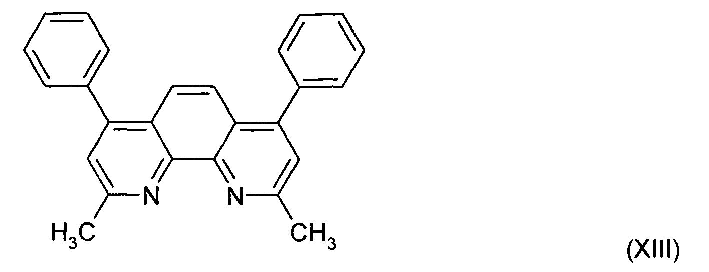

It is desirable for the electron transport finger and/or the hole transport finger to have a surface area of greater than or equal to about 2 square meter per gram (m²/gm). In one embodiment, the electron transport finger and/or the hole transport finger have a surface area of greater than or equal to about 10 m²/gm. In another embodiment, the electron transport finger and/or the hole transport finger have a surface area of greater than or equal to about 20 m²/gm. In yet another embodiment, the electron transport finger and/or the hole transport finger have a surface area of greater than or equal to about 50 m²/gm. In yet another embodiment, the electron transport finger and/or the hole transport finger have a surface area of greater than or equal to about 100 m²/gm.

The conductive surfaces of the first and second substrates for the photovoltaic cell can comprise electrically conductive materials. It is also desirable for the substrates to be transparent to light in the electromagnetic spectrum. It is also desirable for the substrates to be transparent to light having wavelengths of about 300 to 1,100 nanometers. The conductive surfaces of the substrate are generally capable of being patterned so as to selectively undergo chemical bonding with either an electron transporter or a hole transporter. This patterning can be accomplished by using templates, masks, chemical means such as, for example, hydrophobic-hydrophilic interactions, electrical fields, magnetic fields, or the like. The patterning generally permits a substrate to chemically bond with either the electron transporter of the hole transporter, but not both. In one embodiment, the electron transporter comprises reactive groups that only permit chemical bonding with the second substrate. In another, embodiment, the hole transporter comprises reactive groups that only permit chemical bonding with the second substrate. The conductive surface can comprise a single layer or be multilayered if desired.

Examples of suitable electrically conductive materials that may be used in the substrates are metals, semiconductors, inherently conducting polymers, or the like, or combinations comprising at least one of the foregoing. Examples of metals are thin films of platinum, silver, copper, gold, or the like, or a combination comprising at least one of the foregoing metals. Examples of suitable semiconductors are conductive metal oxides such as indium tin oxide, doped indium tin oxide, or the like, or a combination comprising at least one of the foregoing semiconductors. Examples of inherently conducting oxides are detailed above in embodiments describing the electron transport and hole transporters.

The conducting and semiconducting materials that can be used for the conductive surfaces of the substrates can also be in a nanostructured form such as, for example, nanowires, nanofilms, nanorods, or the like. The conductive nanofilms may be deposited on the substrate to form a conductive surface. Useful methods for depositing the nanofilms are expanding thermal plasma (ETP), ion plating, plasma enhanced chemical vapor deposition (PECVD), metal organic chemical vapor deposition (MOCVD) (also called Organometallic Chemical Vapor Deposition (OMCVD)), metal organic vapor phase epitaxy (MOVPE), physical vapor deposition processes such as sputtering, reactive electron beam (e-beam) deposition, and plasma spray. As noted above, templates, masks, or the like, can be used to pattern the conductive surface during the aforementioned processes.

The nanowires may be solid or hollow and can be used to create the conductive surfaces. Using nanowires as conductive surfaces for the substrates facilitates a reduction in the electrical resistance caused by grain boundaries. In one embodiment, it is desirable for the nanowires to be electrically conducting. In another embodiment, it is desirable for the nanowires to be semiconducting. The nanowires can comprise metals and or electrically conductive metal oxides. The nanowires can have reactive molecules on the surface so as to selectively chemically bond with either the electron transporter or the hole transporter. In one embodiment, the nanowires have diameters of about 2 to about 200 nanometers. In another embodiment, the nanowires have diameters of about 5 to about 50 nanometers. In yet another embodiment, the nanowires have diameters of about 10 to about 30 nanometers.

In one embodiment, in one manner of manufacturing the photovoltaic cell, the absorbing molecules are chemically bonded with the inherently conductive polymers, and the charge separators to form the photovoltaic composition. In another embodiment, in one manner of manufacturing the photovoltaic cell, the absorbing molecules are chemically bonded with the inherently conductive polymers, the insulating molecules and the charge separators to form the photovoltaic composition. The composition can then be dissolved into a suitable solvent from which it is cast. Alternatively the composition can be melt blended and further processed by extrusion and or roll milling. After being cast or alternatively after being roll-milled, the composition begins the process of self-assembly. The self assembly can occur by the use of templates, masks, electrical fields, magnetic fields, shear fields, specific chemical interactions such as, for example, hydrophobic-hydrophilic interactions

The process of self-assembly promotes the electron transporter and the hole transporter to phase separate into phases having a geometry and a thickness effective to permit the efficient absorption of light by the absorber. It is desirable for the phase that functions as the electron transporter to be in the form of cylinders and to be close packed in a manner similar to that seen in some block copolymers. In one embodiment, the cylinders substantially comprise the inherent polymer that functions as the electron transporter, while the matrix substantially comprises the inherently conducting polymer that functions as the hole transporter. In another embodiment, the cylinders comprise the inherently conducting polymer that functions as the hole transporter, while the matrix comprises the inherently conducting polymer that functions as the electron transporter.

It is generally desirable for the cylinders to have aspect ratios of greater than or equal to about 2. In one embodiment the aspect ratio is greater than or equal to about 5, while in another embodiment, it greater than or equal to about 10. When the phases are in the form of cylinders, it is desirable for the cylinders to have lengths of greater than or equal to about 1 micrometer. In one embodiment, the cylinder length can be greater than or equal to about 10 micrometers, while in another embodiment, it is greater than or equal to about 50 micrometers. It is desirable for the cylinders to have diameters of greater than or equal to about 2 nanometers. In one embodiment it is desirable for the cylinders to have diameters of greater than or equal to about 5 nanometers, while in another embodiment it is greater than or equal to about 10 nanometers.

In one embodiment, after the self-assembly has occurred, the materials used to provide electron transport and/or the hole transport can be crosslinked to facilitate improved charge transport. Cross-linking will fuse the electron transport blocks in each layer or cylinder into a single electron transport molecular pathway, thereby improving transport and mechanically stabilizing the integrity to provide robustness to the structure.

In another embodiment related to the photovoltaic cell 10 depicted in the Figure 3, in another method of manufacturing the photovoltaic cell, the self-assembly involves promoting self-aggregation of the electron conducting polymeric nano-fiber bundles into a hole transport matrix. To accomplish this, two types of electron transport polymers are utilized. The first electron transport polymer is not sheathed. The second electron transport polymer is chemically bonded to an absorbing molecule and to sheathing. The absorbing molecule and sheathing on this second electron transport polymer will not cover the entire surface of the second electron transport polymer, leaving a portion of the polymer unsheathed. If desired, the unsheathed surfaces of both forms will be functionalized to bind to each other. For example this can be accomplished by having both hydrogen bond donor and acceptor groups on these electron transport polymeric surfaces. When these two forms are heated in a hydrophobic ionic liquid they will spontaneously form nanometer diameter fibers containing unsheathed polymers in the core and sheathed polymers on the exterior of the fibers. As detailed above, the end groups of the electron transport polymers and the hole transport polymers will be designed to bind to the respective substrates. The ionic liquid can be solidified after assembly by the crosslinking of dissolved hole transport polymers.

In yet another embodiment, pertaining to the manufacturing of photovoltaic cells, the electron-transport block consists of a psuedo core-shell structure, where the core and the shell constitute the electron transporter and the electrically insulating sheathing materials respectively. The hole-transport block also consists of a psuedo core-shell structure, where the core and the shell constitute the hole transporter and the electrically insulating sheathing materials respectively. The core-shell block copolymers are mixed with the light absorber material, which can be in the form of nanoparticles from a solution phase or in the molten state. The mixture is then deposited on a patterned (electrode) substrate. It can be deposited separately on either the first substrate or the second substrate. The deposition can occur via processes involving spin coating, solution casting, or the like. Following the deposition of the block copolymer/light absorber mixture, the pre-patterned substrate without the coating is brought into intimate contact with the surface of the block copolymer that is deposited on the other substrate.

In order to pre-pattern the electrode substrates, a self assembled monolayer (SAM) or a polymer brush is first applied to at least one substrate, which is then patterned with techniques such as e-beam lithography, nano-imprinting, extreme UV lithography or block copolymer lithography. Using this patterning process, the electrode substrates are both chemically and topographically patterned. The first and the second substrates are patterned with SAM (or polymer brushes) having different chemical characteristics. More specifically, the chemical nature of one of the patterned electrodes should be only compatible with the electron-forming block and incompatible with the hole-forming block of the block copolymer. Similarly, the other patterned electrode should only be compatible with the hole-forming block of the block copolymer.

These requirements ensure the appropriate electrical contact between each block of the block copolymer and the corresponding electrode substrate thereby preventing short circuits.

Different SAMs (polymer brushes) can be used for each electrode substrate. In another embodiment the same SAM (polymer brush) is applied to both electrodes, and subsequently only one the SAM-electrodes is chemically modified by subjecting it to blanket UV (radiation) exposure or ozone exposure or heat treatment.

The self-assembly of the block copolymer/light absorber mixture can take place using a variety of processes, such as heat treatment, pressure application, in the presence of solvent or vapors, or in the presence of external fields, such as electrical, magnetic, shear or combinations of the above processes, which result in the phase separation of the copolymer blocks in to periodic and well-defined domains. The dimensions and morphology of these domains are controlled by the molecular weight, volume fraction and degree of interaction of the block components and the light absorbing material (absorber). Dimensions are of the order of a few nanometers to hundreds of nanometers, and morphologies are spherical, cylindrical, lamellar, double gyroid and other interpenetrated phases. The preferred morphologies for this application are lamellar or cylindrical

In one embodiment, the light absorbing material (absorber) is chosen such that upon self-assembly it segregates into the interfaces between the hole forming block and the pseudo core-shell electron-forming block. Surface functionalization of the light-absorbing material may or may not be required for this purpose. Self-assembly of block copolymer/light absorbing mixtures on the pre-patterned electrode substrates provides the means to achieve perpendicular orientation of block copolymer domains (phases) especially for cylindrical or lamellar forming block copolymer/light absorber mixtures.

The photovoltaic cells manufactured by the aforementioned method are advantageous in that they can provide an energy conversion efficiency of greater than or equal to about 10%. !n another embodiment, the photovoltaic cell can provide an energy conversion efficiency of greater than or equal to about 20%. In yet another embodiment, the photovoltaic cell can provide an energy conversion efficiency of greater than or equal to about 30%. In addition, the photovoltaic cells manufactured by the aforementioned methods are versatile and flexible, have a light weight and can be manufactured by flexible methods such as using roll mills.

For the sake of good order, various aspects of the invention are set out in the following clauses:-
1. A photovoltaic cell comprising:
   an absorber that can absorb electromagnetic radiation;
   a first substrate comprising a first conductive surface;
   a second substrate comprising a second conductive surface that is opposed to the first conductive surface and faces the first conductive surface of the first substrate;
   an electron transporter that is in electrical communication with the second conductive surface of the second substrate, but is electrically insulated from the first substrate; and
   a hole transporter that is in electrical communication with the first conductive surface of the first substrate, but is electrically insulated from the second substrate; wherein the hole transporter and/or the electron transporter are chemically bonded to an electrically insulating sheath; and wherein the hole transporter and/or the electron transporter are chemically bonded to the absorber.
2. The photovoltaic cell of Clause 1, wherein the first substrate and/or the second substrate is transparent to light having a wavelength of about 300 to about 1,100 nanometers.
3. The photovoltaic cell of Clause 1, wherein the conductive surface of the first substrate is in electrical communication with the conductive surface of the second substrate through an electrical circuit that is external to the photovoltaic cell.
4. The photovoltaic cell of Clause 1, wherein the conductive surfaces of the first and/or the second substrate comprise one or more layers of electrically conducting materials that can comprise metals, semiconductors, doped semiconductors, intrinsically conducting polymers, or a combination comprising at least one of the foregoing materials.
5. The photovoltaic cell of Clause 1, wherein the electron transporter and hole transporter are in the form of interdigitated fingers that have a characteristic dimension of greater than or equal to about 2 nanometers.
6. The photovoltaic cell of Clause 1, wherein the hole transporter and the electron transporter comprise intrinsically conductive polymers.
7. The photovoltaic cell of Clause 1, wherein the hole transporter and/or the electron transporter comprise hydrazone compounds, styryl compounds, diamine compounds, aromatic tertiary amine compounds, butadiene compounds, indole compounds, carbazole derivatives, triazole derivatives, imidazole derivatives, oxadiazole derivatives having an amino group, triphenylmethane, bis(4-diethylamine-2-methylphenyl) phenylmethane, stylbene, hydrozone; aromatic amines comprising tritolylamine; arylamine; enamine phenanthrene diamine; N,N'-bis-(3,4-dimethylphenyl)-4-biphenyl amine; N,N'-bis-(4-methylphenyl)-N,N'-bis(4-ethylphenyl)-1,1'-3,3'-dimethylbiphenyl)-4,4'-diamine; 4-4'-bis(diethylamino)-2,2'-dimethyltriphenylmethane; N,N'-diphenyl-N,N'-bis(3-methylphenyl)-[1,1'-biphenyl]-4,4'-diamine; N,N'-diphenyl-N,N'-bis(4-methylphenyl)-1,1'- biphenyl-4,4'-diamine; N,N'-diphenyl-N,N'-bis(alkylphenyl)-1,1'-biphenyl-4,4'-diamine; and N,N'-diphenyl-N,N'-bis(chlorophenyl)-1,1'-biphenyl-4,4'-diamine; 1,1-bis(4-di-p-tolylaminophenyl)cyclohexane; 1,1-bis(4-di-p-tolylaminophenyl)-4-phenylcyclohexane; 4,4'-bis(diphenylamino)quadriphenyl; bis(4-dimethylamino-2-methylphenyl)-phenylmethane; N,N,N-Tri(p-tolyl)amine; 4-(di-p-tolylamino)-4'-[4(di-p-tolylamino)-styryl] stilbene; N,N,N',N'-tetra-p-tolyl-4-4'-diaminobiphenyl; N,N,N',N'-tetraphenyl-4,4'-diaminobiphenyl; N,N,N',N'-tetra-1-naphthyl-4,4'-diaminobiphenyl; N,N,N',N'-tetra-2-naphthyl-4,4'-diaminobiphenyl; N-phenylcarbazole; 4,4'-bis[N-(1-naphthyl)-N-phenylamino]biphenyl; 4,4'-bis[N-(1-naphthyl)-N-(2-naphthyl)amino]biphenyl; 4,4"-bis[N-(1-naphthyl)-N-phenylamino]p-terphenyl; 4,4'-bis[N-(2-naphthyl)-N-phenylamino]biphenyl; 4,4'-bis[N-(3-acenaphthenyl)-N-phenylamino]biphenyl; 1,5-bis[N-(1-naphthyl)-N-phenylamino]naphthalene; 4,4'-bis[N-(9-anthryl)-N-phenylamino]biphenyl; 4,4"-bis[N-(1-anthryl)-N-phenylamino]-p-terphenyl; 4,4'-bis[N-(2-phenanthryl)-N-phenylamino]biphenyl; 4,4'-bis[N-(8-fluoranthenyl)-N-phenylamino]biphenyl; 4,4'-bis[N-(2-pyrenyl)-N-phenylamino]biphenyl; 4,4'-bis[N-(2-naphthacenyl)-N-phenylamino]biphenyl; 4,4'-bis[N-(2-perylenyl)-N-phenylamino]biphenyl; 4,4'-bis[N-(1-coronenyl)-N-phenylamino]biphenyl; 2,6-bis(di-p-tolylamino)naphthalene; 2,6-bis[di-(1-naphthyl)amino]naphthalene; 2,6-bis[N-(1-naphthyl)-N-(2-naphthyl)amino]naphthaiene; N,N,N',N'-tetra(2-naphthyl)-4,4"-diamino-p-terphenyl; 4,4'-bis {N-phenyl-N-[4-(1-naphthyl)-phenyl]amino} biphenyl; 4,4'-bis[N-phenyl-N-(2-pyrenyl)amino]biphenyl; 2,6-bis[N,N-di(2-naphthyl)amine]fluorine; 1,5-bis[N-(1-naphthyl)-N-phenylamino]naphthalene; or a combination comprising at least one of the foregoing.
8. The photovoltaic cell of Clause 6, wherein the intrinsically conducting polymers are poly(acetylene) and its derivatives; poly(thiophenes) and its derivatives; poly(3,4-ethylenedioxythiophene) and poly(3,4-ethylenedithiathiophene) and their derivatives; poly(isathianaphthene), poly(pyridothiophene), poly(pyrizinothiophene), and their derivatives; poly(pyrrole) and its derivatives; poly(3,4-ethylenedioxypyrrole) and its derivatives; poly(aniline) and its derivatives; poly(phenylenevinylene) and its derivatives; poly(p-phenylene) and its derivatives; poly(thionapthene), poly(benzofuran), and poly(indole) and their derivatives; poly(dibenzothiophene), poly(dibenzofuran), poly(carbazole) and their derivatives; poly(bithiophene), poly(bifuran), poly(bipyrrole), and their derivatives; poly(thienothiophene), poly(thienofuran), poly(thienopyrrole), poly(furanylpyrrole), poly(furanylfuran), poly(pyrolylpyrrole), and their derivatives; poly(terthiophene), poly(terfuran), poly(terpyrrole), and their derivatives; poly(dithienothiophene), poly(difuranylthiophene), poly(dipyrrolylthiophene), poly(dithienofuran), poly(dipyrrolylfuran), poly(dipyrrolylpyrrole) and their derivatives; poly(phenyl acetylene) and its derivatives; poly(biindole) and derivatives; poly(dithienovinyiene), poly(difuranylvinylene), poly(dipyrrolylvinylene) and their derivatives; poiy(1,2-trans(3,4-ethylenedioxythienyl)vinylene), poly(1,2-trans(3,4-ethylenedioxyfuranyl)vinylene), poly(1,2-trans(3,4-ethylenedioxypyrrolyl)vinylene), and their derivatives; poly(bis-thienylarylenes) and poly(bis-pyrrolylarylenes) and their derivatives; poly(dithienylcyclopentenone); poly(quinoline); poly(thiazole); poly(fluorene); poly(azulene); or a combination comprising at least one of the foregoing intrinsically conducting polymers.
9. The photovoltaic cell of Clause 1, wherein the electron transporter is a functionalized fullerene, a 6,6-phenyl-C61-butyl acid-methylester, difluorovinyl-(hetero)arylene, a 3-(1,1-difluoro-alkyl)thiophene group, a pentacene, a poly(3-hexylthiophene), an α,ω-substituted sexithiophene, an n-decapentafluoroheptyl-methylnaphthalene-1,4,5,8-tetracarboxylic diimide, a dihexyl-quinquethiophene, poly(3-hexylthiophene), a poly(3-alkylthiophene), a di-hexyl-hexathiophene, a dihexyl-anthradithiophene, a phthalocyanine, a C60 fullerene, or a combination comprising at least one of the foregoing electron transporters.
10. The photovoltaic cell of Clause 1, wherein the electrically insulating sheath is bonded to the electron transporter and/or the hole transporter and prevents electrons from recombining with holes; and wherein the electrically insulating sheath has a characteristic dimension that is greater than or equal to 0.2 nanometers.
11. The photovoltaic cell of Clause 10, wherein the electrically insulating sheath can comprise a partial monolayer or multiple layers of electrically insulating material.
12. The photovoltaic cell of Clause 1, wherein the absorber comprises an absorbing molecule and a charge separator that is chemically bonded to the absorbing molecule.
13. The photovoltaic cell of Clause 12, wherein the absorbing molecule comprises at least one long wavelength absorbing molecule capable of absorbing electromagnetic radiation of wavelengths of about 700 to about 1,100 nanometers, and at least one short wavelength absorbing molecule capable of absorbing electromagnetic radiation of wavelengths of about 300 to about 700 nanometers; and wherein the short wavelength absorbing molecule and the long wavelength absorbing molecule are chemically compatible with one another and can reside in a single phase.
14. The photovoltaic cell of Clause 12, wherein the charge separator is a substituted phenothiazine moiety, a substituted carbazole moiety, a substituted dibenzochalcophene moiety, or a combination comprising at least one of the foregoing charge separators.
15. The photovoltaic cell of Clause 12, wherein the charge separator comprises an electron donating moiety and/or a reducing agent.
16. The photovoltaic cell of Clause 1, wherein the absorber has a LUMO level effective to eject an electron directly into the conduction band of the electron transporter, and a HOMO level effective to eject a hole directly into the hole conduction band of the hole transporter.
17. A photovoltaic composition comprising:
   an electron transporter optionally bonded to an electrically insulating molecule;
   a hole transporter optionally bonded to an electrically insulating molecule; and
   an absorber that is capable of absorbing electromagnetic radiation; wherein the absorber is chemically bonded to the electron transporter and the hole transporter.
18. The composition of Clause 17, wherein the absorber comprises an absorbing molecule and one or more charge separators and wherein the charge separators are chemically bonded to the absorbing molecule and further wherein the charge separator is a substituted phenothiazine moiety, a substituted carbazole moiety, a substituted dibenzochalcophene moiety, or a combination comprising at least one of the foregoing charge separators.
19. The composition of Clause 18, wherein the absorbing molecule comprises at least one long wavelength absorbing molecule capable of absorbing electromagnetic radiation of wavelengths of about 700 to about 1,100 nanometers, and at least one short wavelength absorbing molecule capable of absorbing electromagnetic radiation of wavelengths of about 300 to about 700 nanometers.
20. A device comprising the composition of Clause 17.
21. A method of manufacturing a photovoltaic cell comprising:
   blending a composition comprising an absorber that is capable of absorbing electromagnetic radiation; an electron transporter and/or a hole transporter; and/or an electrically insulating molecule; and
   depositing the composition upon a substrate.
22. A photovoltaic cell manufactured by the method of Clause 21.

## Claims

1. A photovoltaic cell comprising:
an absorber that can absorb electromagnetic radiation;
a first substrate comprising a first conductive surface;
a second substrate comprising a second conductive surface that is opposed to the first conductive surface and faces the first conductive surface of the first substrate;
an electron transporter that is in electrical communication with the second conductive surface of the second substrate, but is electrically insulated from the first substrate; and
a hole transporter that is in electrical communication with the first conductive surface of the first substrate, but is electrically insulated from the second substrate; wherein the hole transporter and/or the electron transporter are chemically bonded to an electrically insulating sheath; and wherein the hole transporter and/or the electron transporter are chemically bonded to the absorber.

2. The photovoltaic cell of Claim 1, wherein the first substrate and/or the second substrate is transparent to light having a wavelength of about 300 to about 1,100 nanometers.

3. The photovoltaic cell of Claim 1 or 2, wherein the conductive surface of the first substrate is in electrical communication with the conductive surface of the second substrate through an electrical circuit that is external to the photovoltaic cell.

4. The photovoltaic cell of Claim 1, 2 or 3, wherein the conductive surfaces of the first and/or the second substrate comprise one or more layers of electrically conducting materials that can comprise metals, semiconductors, doped semiconductors, intrinsically conducting polymers, or a combination comprising at least one of the foregoing materials.

5. The photovoltaic cell of any preceding Claim, wherein the electron transporter and hole transporter are in the form of interdigitated fingers that have a characteristic dimension of greater than or equal to about 2 nanometers.

6. The photovoltaic cell of any preceding Claim, wherein the hole transporter and the electron transporter comprise intrinsically conductive polymers.

7. A photovoltaic composition comprising:
an electron transporter optionally bonded to an electrically insulating molecule;
a hole transporter optionally bonded to an electrically insulating molecule; and
an absorber that is capable of absorbing electromagnetic radiation; wherein the absorber is chemically bonded to the electron transporter and the hole transporter.

8. The composition of Claim 7, wherein the absorber comprises an absorbing molecule and one or more charge separators and wherein the charge separators are chemically bonded to the absorbing molecule and further wherein the charge separator is a substituted phenothiazine moiety, a substituted carbazole moiety, a substituted dibenzochalcophene moiety, or a combination comprising at least one of the foregoing charge separators.

9. The composition of Claim 8, wherein the absorbing molecule comprises at least one long wavelength absorbing molecule capable of absorbing electromagnetic radiation of wavelengths of about 700 to about 1,100 nanometers, and at least one short wavelength absorbing molecule capable of absorbing electromagnetic radiation of wavelengths of about 300 to about 700 nanometers.

10. A method of manufacturing a photovoltaic cell comprising:
blending a composition comprising an absorber that is capable of absorbing electromagnetic radiation; an electron transporter and/or a hole transporter; and/or an electrically insulating molecule; and
depositing the composition upon a substrate.
